(19) Europäisches Patentamt
European Patent Office
Office européen des brevets

(11) Numéro de publication: **0 061 952**
**A1**

(12) # DEMANDE DE BREVET EUROPEEN

(21) Numéro de dépôt: **82400458.4**

(51) Int. Cl.$^3$: **H 03 B 5/18**

(22) Date de dépôt: **12.03.82**

(30) Priorité: **27.03.81 FR 8106185**

(43) Date de publication de la demande:
**06.10.82 Bulletin 82/40**

(84) Etats contractants désignés:
**BE CH DE GB IT LI NL SE**

(71) Demandeur: **THOMSON-CSF**
**173, Boulevard Haussmann**
**F-75360 Paris Cedex 08(FR)**

(72) Inventeur: **Bert, Alain**
**THOMSON-CSF SCPI 173, bld Haussmann**
**F-75360 Paris Cedex 08(FR)**

(72) Inventeur: **Kaminsky, Didier**
**THOMSON-CSF SCPI 173, bld Haussmann**
**F-75360 Paris Cedex 08(FR)**

(74) Mandataire: **Taboureau, James et al,**
**THOMSON-CSF SCPI 173, Bld Haussmann**
**F-75360 Paris Cedex 08(FR)**

(54) **Oscillateur hyperfréquence à résonateur diélectrique du type en circuit hybride compact.**

(57) L'invention concerne les oscillateurs à très haute fréquence et à grande stabilité en fonction de la température, utilisant un transistor couplé par une ligne de transmission du type microbande avec un résonateur diélectrique à très faible coefficient de température.

L'oscillateur selon l'invention comporte un transistor (10) qui peut être soit à effet de champ, soit du type bipolaire, et un substrat (1) isolant métallisé sur une face formant plan de masse (4), ce dernier débordant le substrat (1) en un point voisin de deux lignes (2, 3) de transmission gravées sur la face du substrat (1) opposée au plan de masse (4), le transistor (10) étant soudé sur un ressaut (41) du bac formant plan de masse (4).

Application à la réception des micro-ondes diffusées par satellite terrestre.

FIG. 2

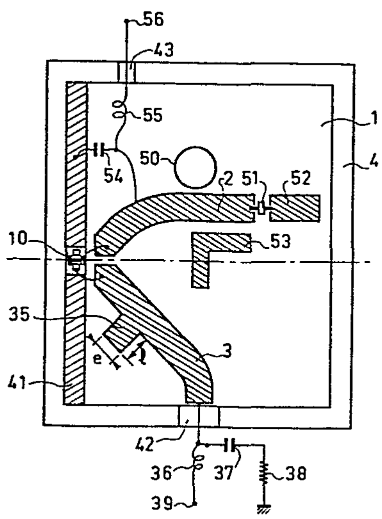


EP 0 061 952 A1

# OSCILLATEUR HYPERFREQUENCE A RESONATEUR DIELECTRIQUE DU TYPE EN CIRCUIT HYBRIDE COMPACT

L'invention concerne les oscillateurs à très haute fréquence et à grande stabilité utilisant un élément actif couplé par une ligne de transmission à un résonateur diélectrique à très faible coefficient de température.

Pour les fréquences supérieures au gigahertz, l'élément actif de tels oscillateurs peut être :

- soit une diode Gunn comme dans la demande de brevet français 78 26 553 déposée le 15 Septembre 1978 par la Demanderesse ;

- soit un transistor comme dans la demande de brevet 80 19 917 déposée le 16 Septembre 1980 par la Demanderesse.

Les avantages présentés par l'utilisation du transistor sont :

- une puissance plus élevée ;

- un meilleur rendement ;

- une plus grande facilité d'intégration sur un seul substrat de l'ensemble formé par l'élément actif et le reste de l'oscillateur.

En revanche, la réalisation est plus complexe et le prix de revient peut être trop élevé pour une application de type "grand public" telle que la réception de télévision par satellite.

L'invention tend à éviter ce dernier inconvénient en proposant une réalisation plus facile à fabriquer, tout en conciliant les exigences de stabilité tant en fréquence qu'en température, de compacité et de faible prix de revient, grâce à l'utilisation d'éléments fabriqués en série.

L'oscillateur hyperfréquence du type à résonateur diélectrique, comporte un transistor qui peut être soit bipolaire, soit à effet de champ, et un substrat isolant métallisé sur une face formant plan de masse et portant sur l'autre face deux lignes de transmission du type microbande, dont l'une est couplée à un résonateur diélectrique. Il est caractérisé en ce que le plan de masse déborde le substrat en formant un ressaut situé au même niveau que les bandes gravées des lignes de transmission et voisin des extrêmités de celles-ci, le transistor ayant une électrode soudée à la masse en un point

situé sur ledit ressaut et deux autres électrodes reliées aux extrêmités respectives des deux lignes de transmission.

L'invention sera mieux comprise, et d'autres caractéristiques apparaitront, au moyen de la description qui suit, et des dessins qui l'accompagnent, parmi lesquels :

- les figures 1 et 2 représentent respectivement en coupe et en vue par dessus un exemple de réalisation de l'invention ;

- la figure 3 est une vue en perspective d'un support utilisable pour réaliser l'exemple des figures 1 et 2 ;

- la figure 4 est un schéma de branchement d'un transistor dans le cas de l'exemple des figures 1 et 2 ;

- les figures 5, 7, 8 et 9 représentent des variantes de ligne de transmission côté "grille" du transistor ;

- la figure 6 représente une variante de la figure 4.

Dans l'exemple représenté aux figures 1 et 2, le substrat servant à constituer les lignes de transmission du type "microbande" 2 et 3 est réalisé sous la forme d'une couche 1 d'alumine garnissant le fond d'un bac conducteur rectangulaire 4, présentant une surélévation du fond formant un ressaut 41 suivant l'un des bords internes du bac. Un couvercle (non représenté) peut être ajouté pour fermer le bac, des encoches 42 et 43 dans le bord facilitant le raccordement des lignes 2 et 3 avec les sources de polarisation et/ou d'alimentation et la charge d'utilisation. Dans une variante de réalisation, on effectue les raccordements avec les sources et la charge en utilisant des passages traversant le bac.

Le transistor 10 représenté par un simple rectangle, est placé sur le ressaut 41. Il pourrait être soudé à l'envers.

A titre d'exemple, le transistor étant monté à l'endroit, sur son support 101 (figure 3) du type L.I.D. (de l'anglais leadless inverted device), la soudure à l'envers doit s'entendre en ce qui concerne l'ensemble du support 101 et du transistor 10.

Le branchement à réaliser est du type représenté à la figure 4, soit :

- la source S à la masse (ressaut 41) par une connexion 421 ;
- la grille G à la ligne 2 par une connexion 21 ;
- le drain D à la ligne 3 par une connexion 31.

On pourrait permuter drain et source, en changeant le sens de l'alimentation.

Dans le cas pratique du support L.I.D. (figure 3) ce dernier présente des faces parallèles conductrices situées à des niveaux différents destinées aux raccordements :

- du transistor 10 par collage ou soudure de sa face postérieure sur la face 100 du support 101 ;

- des connexions 21 et 31, respectivement sur les faces 22 et 32 séparées par une encoche isolante ;

- de la connexion de masse raccordée à la face 100 sous forme de plusieurs connexions de petit diamètre 421, en vue de limiter l'inductance propre de raccordement ;

- des électrodes S, G et D par soudure de la face 34 (S) sur le ressaut 41, de la face 23 (G) sur la ligne 2 et de la face 33 (D) sur la ligne 3.

La ligne de transmission 2 est légèrement coudée afin de diminuer l'encombrement de l'ensemble oscillateur. Elle constitue, avec ses éléments auxiliaires (50, 51, 52 et 53) un dispositif destiné à favoriser une fréquence d'oscillation prédéterminée fixée par la fréquence de résonance de l'élément 50. L'élément 50 est un résonateur constitué par exemple (figure 5) par un tronçon cylindrique en céramique à forte constante diélectrique relative, soit 35 à 40, présentant de faibles pertes en très haute fréquence et une bonne stabilité en température. La formule du matériau constituant le résonateur 50 est par exemple la suivante :

$$Zr_x\, Sn_{1-x}\, Ti\, O_4$$

dans laquelle x est compris entre 0,2 et 0,4.

Les règles de positionnement du résonateur 50 sont classiques. Les éléments de ligne de propagation 52 et 53 constituent un exemple de solution possible, représenté à la figure 5.

Suivant le schéma des figures 2 et 5, la ligne de transmission 2, reliée à la grille du transistor à effet de champ, aboutit, du côté opposé à cette grille à une charge résistive 51 au delà de laquelle on trouve un élément 52 de ligne "quart d'onde".

Toutes les longueurs d'onde dont il s'agit concernent la propagation

dans le milieu diélectrique des lignes de type microbande gravées sur le substrat, c'est à dire la couche d'alumine 1. Le résonateur 50 est placé près de la ligne 2 à une distance permettant de rendre maximale la puissance de sortie et centré sur un axe XX perpendiculaire à la microbande. De l'autre côté de la ligne, une équerre 53 formée de 2 éléments "quart d'onde" A et B, a son élément A disposé le long de l'axe XX.

En outre, les dispositions suivantes sont à respecter :

1°/ La ligne de transmission est de forme coudée à son extrémité la plus éloignée du transistor de manière à faciliter son raccordement avec la sortie 42 du bac 4. En outre, elle comporte une sorte d'ergot 35 réalisant une adaptation d'impédance entre le drain (ou la source selon le cas) du transistor et la ligne 3 chargée par une résistance d'utilisation 38.

L'ergot 35 est un élément de ligne microbande perpendiculaire à la direction générale de la ligne 3. On ajuste par tâtonnement sa largeur "e" et sa longueur "l" de façon à obtenir la puissance maximale du côté de l'utilisation. La longueur de l'ergot est généralement inférieure au quart de la longueur d'onde, réalisant ainsi une capacité au niveau du raccordement de l'ergot sur la ligne 3.

En outre, la résistance d'utilisation 38 est découplée de façon classique de la tension continue d'alimentation (appliquée au point 39) grâce à une inductance 36 et à une capacité 37.

2°/ La ligne de transmission 2 est découplée, à son retour "haute fréquence" à la masse du bac 4 par une capacité 54 et une inductance 55, la polarisation de grille étant appliquée au point 56.

Selon une variante de réalisation représentée partiellement à la figure 6, les lignes de transmission 2 et 3 sont couplées par une disposition du type interdigité. Les bords voisins des lignes 2 et 3, au voisinage du transistor, sont découpés suivant des profils crénelés qui s'emboîtent mutuellement. Le montage du transistor est alors du type "source commune" avec couplage capacitif. On peut également permuter source et drain (montage en drain commun).

Dans une variante de réalisation de la figure 2, représentée à la figure 7 (où les mêmes références désignent des éléments identiques ou analogues), l'équerre 53 est placée de façon différente. En effet la branche A est

parallèle à la ligne 2 au lieu de lui être perpendiculaire et la branche B est la plus éloignée de l'axe XX et non la plus proche. En outre l'équerre est déplacée d'un quart de longueur d'onde vers l'extrémité de la ligne 2. La charge 51 et l'élément de ligne 52 demeurent inchangés.

Dans les variantes de réalisation de la figure 2 représentées aux figures 8 et 9, on a supprimé l'équerre 53. On a disposé à l'extrémité de la ligne 2, après la charge 51 :

- soit une ligne demi-onde 80 (figure 8) à la place de la ligne "quart d'onde 53" ;
- soit une ligne demi-onde 90 parallèle à la ligne 53 et très proche de celle-ci.

Outre le montage en "source commune" avec couplage capacitif des lignes de grille et de drain, illustré par la figure 6, on mentionnera d'autres montages possibles :

- source commune avec inductance à la masse ;
- drain commun ;
- grille commune avec inductance à la masse.

Dans le cas des figures 5 et 7, on règle la valeur de la résistance 51 de telle sorte que l'oscillateur soit stable en l'absence de résonateur diélectrique. Puis on dispose l'équerre 53 de façon à réaliser un filtre de réjection pour les fréquences situées de part et d'autre de la fréquence d'oscillation choisie (celle du résonateur 50). Enfin on place le résonateur 50 dans un plan (plan diamétral passant par l'axe XX) où le filtre de réjection ramène un court-circuit.

Dans le cas des figures 8 et 9, la résistance 51 est mise à la masse par une impédance nulle ou faible de part et d'autre de la fréquence d'oscillation choisie (celle du résonateur 50) pour laquelle cette impédance devient infinie. Le résonateur est placé à un quart de longueur d'onde de la résistance 51.

Le substrat isolant supportant les lignes de transmission peut être réalisé avec des diélectriques autres que l'alumine pure, notamment la silice ou une combinaison de verre et de polytétrafluoréthylène (téflon).

Enfin à défaut de support du type L.I.D. le transistor (à effet de champ ou bipolaire) peut être utilisé à l'état nu, ou monté à l'endroit sur un boitier

sans couvercle, lequel est utilisé comme support de manutention pour faciliter la soudure à l'envers.

# REVENDICATIONS

1. Oscillateur hyperfréquence du type à résonateur diélectrique (50), comportant un transistor (10) qui peut être soit bipolaire, soit à effet de champ, et un substrat isolant (1) métallisé sur une face formant plan de masse (4) et portant sur l'autre face deux lignes de transmission (2,3) du type microbande, dont l'une est couplée à un résonateur diélectrique (50), caractérisé en ce que le plan de masse déborde le substrat (1) en formant un ressaut (41) situé au même niveau que les bandes gravées des lignes de transmission (2,3) et voisin des extrémités de celles-ci, le transistor (10) ayant une électrode soudée à la masse en un point situé sur ledit ressaut (41) et deux autres électrodes reliées aux extrémités respectives des deux lignes de transmission (2,3).

2. Oscillateur selon la revendication 1, caractérisé en ce que le transistor (10) est monté à l'endroit sur un support (101) permettant la soudure à l'envers sur une petite surface comprenant une partie du ressaut (41) et de chacune des lignes de transmission (2, 3).

3. Oscillateur selon la revendication 2, caractérisé en ce que ledit support est du type L.I.D. présentant une première face (100) sur laquelle le transistor (10) peut être monté à l'endroit et des faces (22, 23, 32, 33, 34) parallèles situées à deux niveaux différents de celui de ladite première face.

4. Oscillateur suivant l'une quelconque des revendications 1 à 3, caractérisé en ce que le transistor (10), du type à effet de champ, a sa grille reliée à une première ligne (2) microbande gravée sur ledit substrat (1), couplée à un résonateur diélectrique (50) et terminée par une résistance (51) reliée à une deuxième ligne (3) microbande gravée sur le substrat (1).

5. Oscillateur selon l'une quelconque des revendications 1 à 3, caractérisé en ce que le transistor (10) du type bipolaire, a sa grille reliée à une première ligne (2) microbande gravée sur le substrat (1), couplée à un résonateur diélectrique (50) et terminée par une résistance (51) reliée à une deuxième ligne (3) microbande gravée sur le substrat (1).

FIG.1

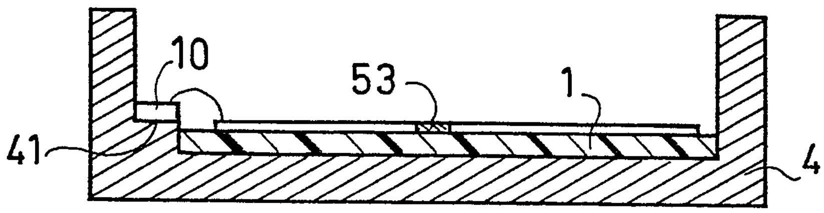


FIG.2

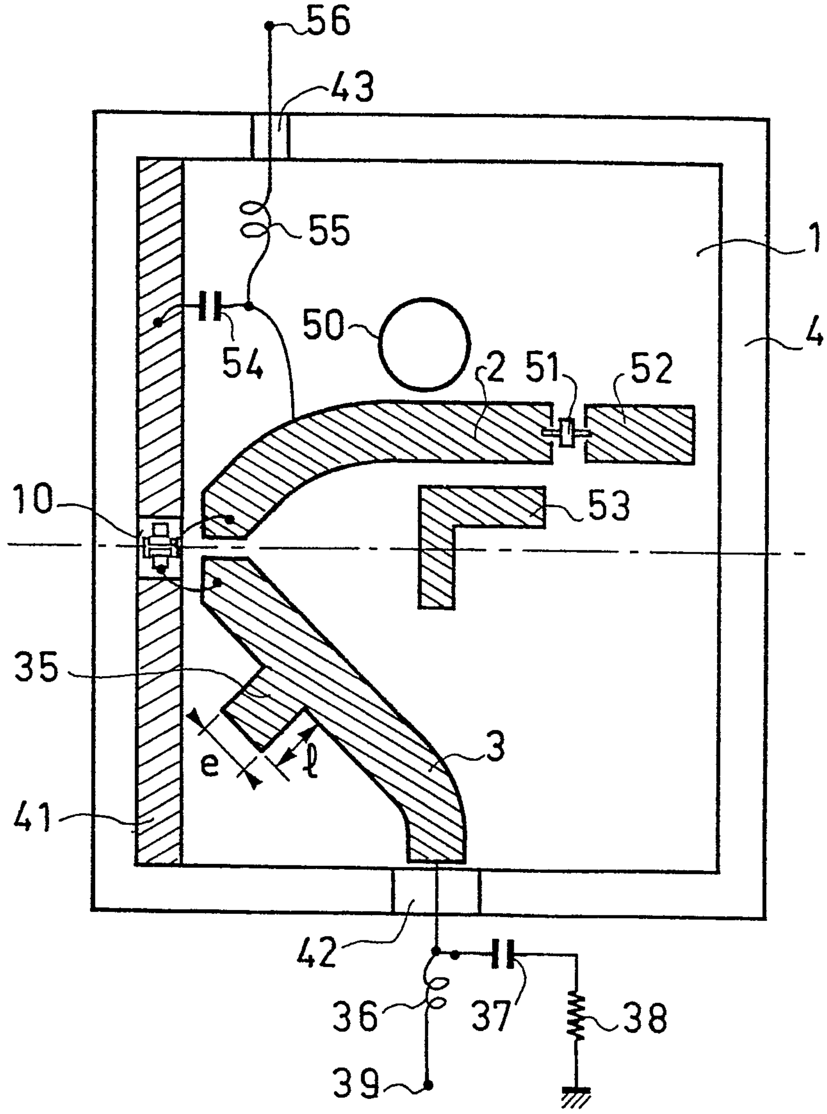

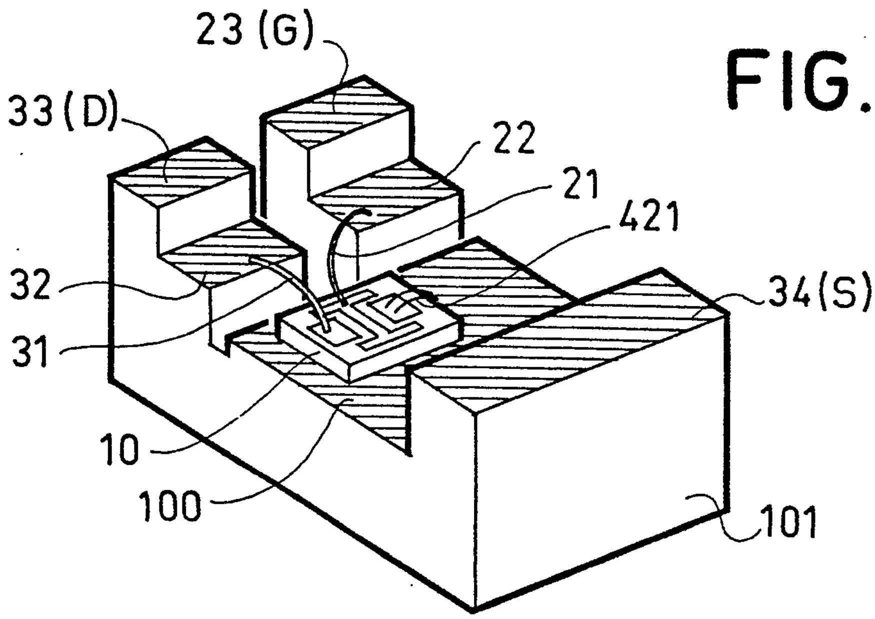


FIG. 3

FIG. 4

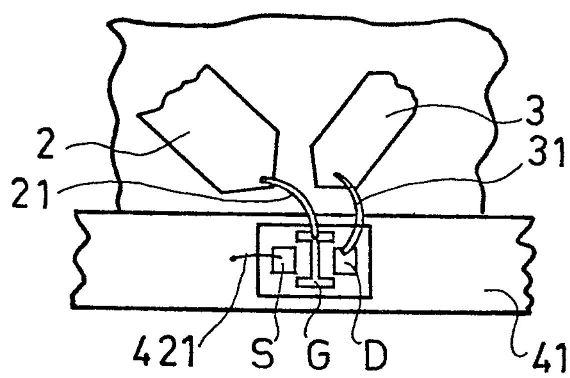


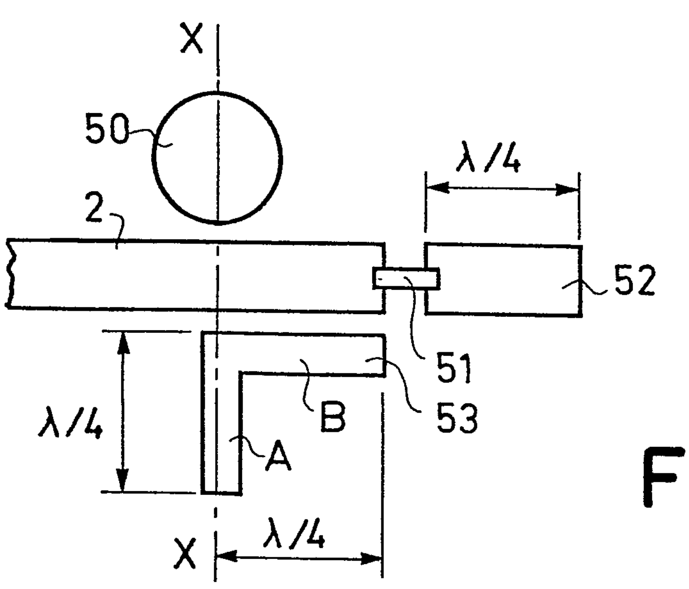


FIG. 5

FIG.8

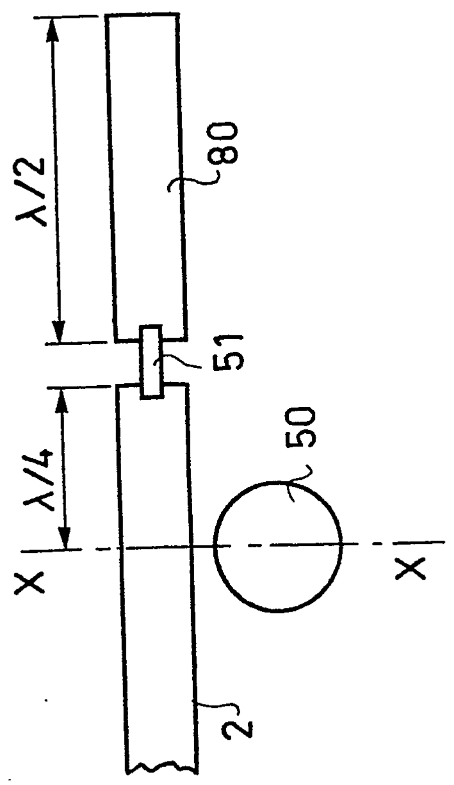


FIG.9

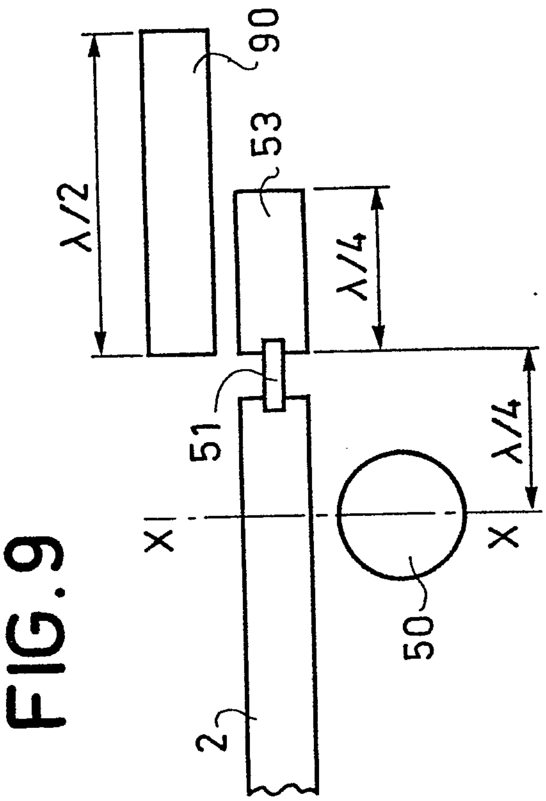


FIG.6

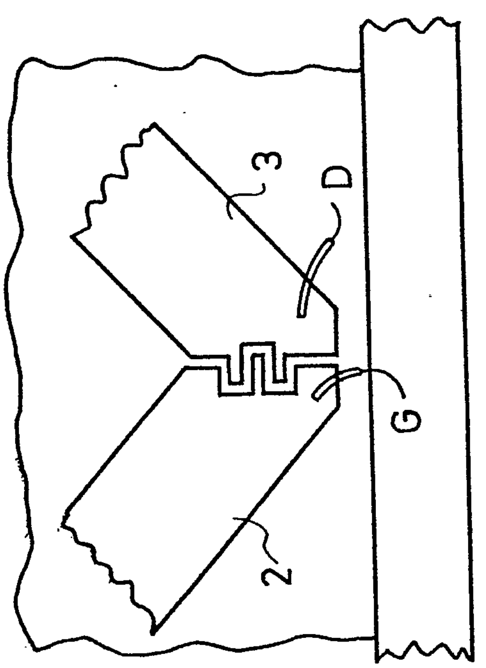


FIG.7

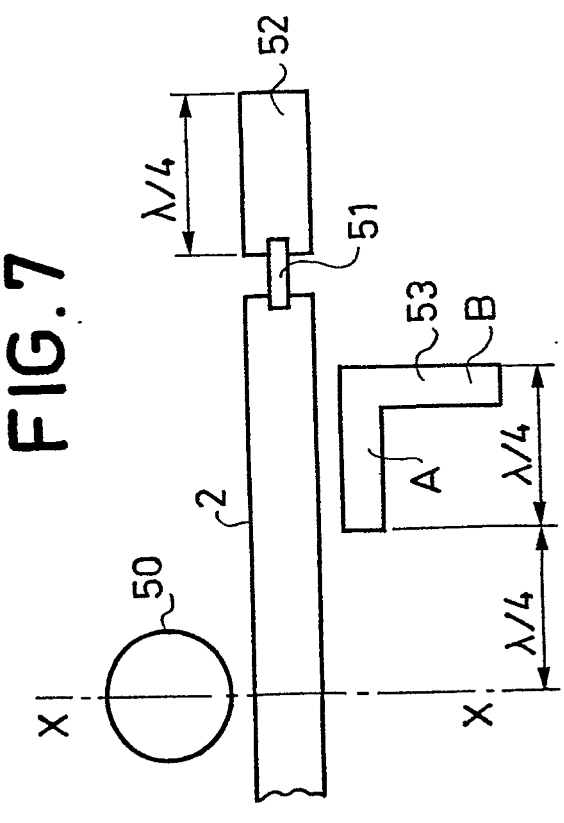

0061952

Office européen des brevets

# RAPPORT DE RECHERCHE EUROPEENNE

Numéro de la demande
EP 82 40 0458

## DOCUMENTS CONSIDERES COMME PERTINENTS

| Categorie | Citation du document avec indication, en cas de besoin, des parties pertinentes | Revendication concernee | CLASSEMENT DE LA DEMANDE (Int. Cl. 3) |
|---|---|---|---|
| Y | 1979 IEEE MTT-S INTERNATIONAL MICROWAVE SYMPOSIUM DIGEST, 1979, NEW YORK (US)<br>T. SAITO et al.: "A 6 GHz highly stabilized GaAs FET oscillator using a dielectric resonator"<br>pages 197-199<br>* page 197, en entier; figure 1 *<br>-- | 1,4 | H 03 B 5/18 |
| Y | 1979 IEEE MTT-S INTERNATIONAL MICROWAVE SYMPOSIUM DIGEST, 1979 NEW YORK (US)<br>K. MISHIMA et al.: "FM noise of transmission-type injection-locked GaAs FET oscillators and amplifiers"<br>pages 194-196<br>* page 194, colonne de gauche, alinéa 2; figure 1 *<br>-- | 1,4 | DOMAINES TECHNIQUES RECHERCHES (Int. Cl. 3)<br>H 03 B<br>H 03 F |
| Y | DE - A - 3 007 581 (MURATA)<br>* page 7, ligne 28 - page 9, ligne 26; figures 2A-2C *<br>-- | 1,4 | |
| Y | DE - A - 2 837 817 (FUJITSU)<br>* page 17, ligne 8 - page 19, ligne 23; figure 5 *<br>-- ./.. | 1,4 | |

Le present rapport de recherche a ete etabli pour toutes les revendications

| Lieu de la recherche | Date d achevement de la recherche | Examinateur |
|---|---|---|
| La Haye | 5 juillet 1982 | DHONDT |

CATEGORIE DES DOCUMENTS CITES

X : particulierement pertinent a lui seul
Y : particulierement pertinent en combinaison avec un autre document de la même categorie
A : arriere-plan technologique
O : divulgation non-ecrite
P : document intercalaire
T : theorie ou principe à la base de l invention
E : document de brevet anterieur, mais publie à la date de depôt ou apres cette date
D : cite dans la demande
L : cite pour d autres raisons
& : membre de la même famille, document correspondant

1503 03.82

Office européen des brevets

# RAPPORT DE RECHERCHE EUROPEENNE

Numéro de la demande

EP 82 40 0458

-2-

| DOCUMENTS CONSIDERES COMME PERTINENTS | | | CLASSEMENT DE LA DEMANDE (Int. Cl.3) |
|---|---|---|---|
| Catégorie | Citation du document avec indication, en cas de besoin, des parties pertinentes | Revendication concernée | |
| A | NEC RESEARCH & DEVELOPMENT, no.45, avril 1977 TOKYO (JP) H. ABE et al.: "A high-power microwave GaAs FET oscillator" pages 58-65<br>* page 61, colonne de droite, ligne 5; page 62, colonne de gauche, ligne 3; figures 6,9 *<br>-- | | |
| A | FR - A - 2 382 797 (WESTERN ELECTRIC)<br>* page 7, ligne 8 - page 8, ligne 25; figures 7,8 *<br>-- | 1,4,5 | DOMAINES TECHNIQUES RECHERCHES (Int. Cl.3) |
| A | EDN, vol.13, no.2, février 1968 DENVER (US) "Anatomy of the LID" pages 70-73<br>* en entier *<br>-- | 2,4 | |
| A | EP - A - 0 009 435 (THOMSON-CSF)<br>* page 5, ligne 34 - page 7, ligne 6; figure 6 *<br>----- | 1,4,5 | |